# EUROPÄISCHE PATENTANMELDUNG

(11) **EP 3 905 311 A1**
(43) Veröffentlichungstag der Anmeldung: **03.11.2021**
(21) Anmeldenummer: 20171534.9
(22) Anmeldetag: 27.04.2020
(51) Int. Cl.: H01L 21/67, H01L 21/687, C23C 16/458, C30B 25/10

(54) **VERFAHREN UND VORRICHTUNG ZUM ABSCHEIDEN EINER EPITAKTISCHEN SCHICHT AUF EINER SUBSTRATSCHEIBE AUS HALBLEITERMATERIAL**

(71) Anmelder: Siltronic AG, 81677 München (DE)
(72) Erfinder: Stettner, Thomas, 83329 Waging (DE); Edmaier, Walter, 84384 Wittibreut (DE); Hecht, Hannes, 84489 Burghausen (DE); Lichtenegger, Korbinian, 81669 München (DE)
(74) Vertreter: Staudacher, Wolfgang

(57) **Zusammenfassung**

Verfahren und Vorrichtung zum Abscheiden einer epitaktischen Schicht auf einer Substratscheibe aus Halbleitermaterial. Das Verfahren umfasst
das Anordnen der Substratscheibe und eines Suszeptors in einer Abscheidevorrichtung so, dass die Substratscheibe auf dem Suszeptor aufliegt und der Suszeptor von Armen einer Tragwelle gehalten wird;
das Überprüfen, ob eine Fehlanordnung des Suszeptors bezüglich dessen Lage relativ zur Lage eines ihn umgebenden Vorheizrings besteht;
das Überprüfen, ob eine Fehlanordnung der Tragwelle bezüglich deren Lage relativ zur Lage des Vorheizrings besteht;
beim Vorliegen von mindestens einer der Fehlanordnungen, das Beseitigen der jeweiligen Fehlanordnung; und
das Abscheiden der epitaktischen Schicht auf der Substratscheibe.

## Beschreibung

Gegenstand der Erfindung sind ein Verfahren zum Abscheiden einer epitaktischen Schicht auf einer Substratscheibe aus Halbleitermaterial und eine Vorrichtung zur Durchführung des Verfahrens.

### Stand der Technik / Probleme

Halbleiterscheiben mit einer epitaktischen Schicht sind das Produkt eines solchen Verfahrens und werden für besonders anspruchsvolle Anwendungen in der elektronischen Industrie benötigt. Dementsprechend sind insbesondere auch die Anforderungen an die epitaktische Schicht bezüglich der Gleichmäßigkeit von deren Dicke und der Gleichmäßigkeit der Verteilung von Dotierstoffen in der epitaktischen Schicht herausfordernd. Es besteht daher ein starker Anreiz, Herstellungsbedingungen zu schaffen, die Halbleiterscheiben mit epitaktischer Schicht, die den besonderen Ansprüchen genügen, mit hohen Ausbeuten zugänglich machen.

Das Abscheiden der epitaktischen Schicht auf einer Substratscheibe aus Halbleitermaterial erfolgt üblicherweise mittels CVD (chemical vapor deposition) in einer Abscheidevorrichtung, die eine Substratscheibe aufnehmen kann. Während des Abscheidens der epitaktischen Schicht liegt die Substratscheibe auf einem Suszeptor, der von Tragarmen einer Tragwelle gehalten und von der Tragwelle gedreht wird, wobei ein Abscheidegas über eine freie obere Fläche, die Vorderseite der Substratscheibe, geleitet wird. Die Abscheidevorrichtung verfügt üblicherweise auch über einen Vorrheizring, der durch einen Spalt getrennt um den Suszeptor herum angeordnet ist. Eine obere und eine untere Kuppel (upper dome, lower dome) definieren einen Reaktionsraum, innerhalb dessen die epitaktische Schicht auf der Substratscheibe abgeschieden wird. Strahlungswärme von Lampenbänken wird durch die Kuppeln eingestrahlt, um eine notwendige Abscheidetemperatur bereitzustellen. Abscheidevorrichtungen mit diesen Merkmalen werden kommerziell angeboten. Darüber hinaus kann vorgesehen sein, die Substratscheibe in die Abscheidevorrichtung zu laden und dort auf dem Suszeptor abzulegen oder den Suszeptor mit der darauf abgelegten Substratscheibe in die Abscheidevorrichtung zu laden, wie es beispielsweise in US2018 0 282 900 A1 beschrieben ist.

Es ist lange bekannt, dass eine Fehlanordnung der Substratscheibe bezüglich deren Lage relativ zur Lage des Suszeptors sich nachteilig auf die Ausbeute auswirken kann. Üblicherweise sollte die Substratscheibe zentriert auf dem Suszeptor liegen, so dass die Umfangslinien der Substratscheibe und des Suszeptors konzentrische Kreise bilden.

In JP2017-69 414 A ist beschrieben, wie die Lage der Substratscheibe auf dem Suszeptor mittels eines Kamerasystems überwacht und im Bedarfsfall die Suszeptor-Tragwelle horizontal bewegt wird, um eine Substratscheibe auf dem Suszeptor zu zentrieren.

US2009 0 314 205 A1 befasst sich mit Einzelheiten zu einem Beobachtungssystem, das unter anderem auch die Lage des Vorheizrings überwachen kann.

US2016 0 125 589 A1 beschreibt eine Methode, wie Fehlanordnungen detektiert werden können.

Die Erfinder der vorliegenden Erfindung haben festgestellt, dass Ausbeuteverluste aufgrund vorhandener Partikel, wegen ungleichmäßiger Dicke der epitaktischen Schicht und wegen ungleichmäßiger Dotierstoffverteilung in der epitaktischen Schicht auftreten können, ohne dass dafür eine Fehlanordnung der Substratscheibe bezüglich deren Lage relativ zur Lage des Suszeptors dafür verantwortlich gemacht werden kann.

Aufgabe der vorliegenden Erfindung ist es, den Grund für solche Ausbeuteverluste anzugeben und aufzuzeigen, wie dagegen vorgegangen werden kann.

Die Aufgabe der Erfindung wird gelöst durch ein Verfahren zum Abscheiden einer epitaktischen Schicht auf einer Substratscheibe aus Halbleitermaterial, umfassend das Anordnen der Substratscheibe und eines Suszeptors in einer Abscheidevorrichtung so, dass die Substratscheibe auf dem Suszeptor aufliegt und der Suszeptor von Armen einer Tragwelle gehalten wird;
das Überprüfen, ob eine Fehlanordnung des Suszeptors bezüglich dessen Lage relativ zur Lage eines ihn umgebenden Vorheizrings besteht;
das Überprüfen, ob eine Fehlanordnung der Tragwelle bezüglich deren Lage relativ zur Lage des Vorheizrings besteht;
beim Vorliegen von mindestens einer der Fehlanordnungen, das Beseitigen der jeweiligen Fehlanordnung; und
das Abscheiden der epitaktischen Schicht auf der Substratscheibe.

Die Aufgabe der Erfindung wird darüber hinaus gelöst durch eine Vorrichtung zum Abscheiden einer epitaktischen Schicht auf einer Substratscheibe aus Halbleitermaterial, umfassend
einen Suszeptor,
einen Vorheizring,
eine Tragwelle mit Suszeptor-Tragarmen,
ein Kamerasystem zum Beobachten der Breite eines Abschnitts eines Spalts zwischen dem Suszeptor und dem Vorheizring sowie eines Abstands des Kamerasystems zum Suszeptor,
eine Bildverarbeitungseinrichtung zum Feststellen des Vorliegens einer Fehlanordnung des Suszeptors bezüglich dessen Lage relativ zur Lage des Vorheizrings und/oder einer Fehlanordnung der Tragwelle bezüglich deren Lage relativ zur Lage des Vorheizrings,
eine Antriebseinrichtung zum Verschieben und Kippen der Suszeptor-Tragwelle, und eine Steuerungseinrichtung zum Erzeugen eines Signals beim Vorliegen einer Fehlanordnung, wobei das Signal die Antriebseinrichtung in eine Bewegung versetzt, die die vorliegende Fehlanordnung beseitigt.

Die Erfinder haben herausgefunden, dass die erwähnten Ausbeuteverluste auf Fehlanordnungen zurückgehen können, die bezüglich der Lage des Suszeptors und/oder bezüglich der Lage von dessen Tragwelle relativ zur Lage des Vorheizrings bestehen. Üblicherweise ist vorgesehen, dass zwischen dem Vorheizring und dem Suszeptor ein Spalt vorhanden ist, der entlang des inneren Umfangs des Vorheizrings dieselbe Breite aufweist. Der Vorheizring und der Suszeptor liegen konzentrisch zueinander und der Suszeptor ist horizontal angeordnet. Die Tragwelle ist entlang der vertikalen Achse durch die Mitte des Vorheizrings ausgerichtet.

Eine Fehlanordnung des Suszeptors liegt dementsprechend vor, wenn ihr Grund darin besteht, dass der Suszeptor exzentrisch zum Vorheizring auf den Tragarmen der Tragwelle liegt, oder darin, dass der Suszeptor aus der Horizontalen gekippt auf den Tragarmen der Tragwelle liegt. Eine Fehlanordnung der Tragwelle relativ zur Lage des Vorheizrings besteht, wenn ihr Grund darin besteht, dass die Tragwelle zwar vertikal, aber nicht entlang der vertikalen Achse durch die Mitte des Vorheizrings ausgerichtet ist, oder darin, dass die Tragwelle von der vertikalen Achse durch die Mitte des Vorheizrings gekippt ausgerichtet ist.

Falls der Suszeptor den Vorheizring berührt, werden Partikel erzeugt, die als Verunreinigungen die entstehende Halbleiterscheibe mit epitaktischer Schicht für den vorgesehenen Zweck unbrauchbar machen können. Ausbeuteverluste können auch eintreten, wenn die Breite des Spalts zwischen dem Vorheizring und dem Suszeptor entlang des inneren Umfangs des Vorheizrings wegen einer der genannten Fehlanordnungen variiert. Es besteht dann die Möglichkeit, dass Prozessgas durch Spülgas, das entlang der unteren Seite des Suszeptors geleitet wird, an unterschiedlichen Stellen des Spalts in unterschiedlichem Ausmaß verdünnt wird mit der Folge, dass die Dicke der epitaktischen Schicht und die Verteilung von Dotierstoffen in der epitaktischen Schicht in Umfangsrichtung der Substratscheibe variieren kann.

Die genannten Fehlanordnungen können bereits im kalten Zustand der Abscheidevorrichtung bestehen oder erst im Verlauf des Erhitzens der Abscheidevorrichtung auf Betriebstemperatur auftreten und gegebenenfalls beim Abkühlen in den kalten Zustand, beispielsweise beim Abkühlen auf Raumtemperatur, wieder verschwinden.

Es wird daher vorgeschlagen zu überprüfen, ob mindestens eine der Fehlanordnungen vorliegt und gegebenenfalls die Fehlanordnung beseitigt. Grundsätzlich kann zu diesem Zweck die Abscheidevorrichtung auf Umgebungstemperatur abgekühlt und die jeweilige Fehlanordnung beseitigt werden.

In Fällen, in denen das möglich ist, geschieht dies vorzugsweise durch Bewegen der Tragwelle bei geschlossener Abscheidevorrichtung. In anderen Fällen wird die Abscheidevorrichtung geöffnet und der Grund für die Fehlanordnung beseitigt. Liegt beispielsweise eine Fehlanordnung des Suszeptors vor, weil der Suszeptor zwar horizontal, aber exzentrisch zum Vorheizring auf den Tragarmen der Tragwelle liegt, oder weil der Suszeptor zwar konzentrisch zum Vorheizring, aber aus der Horizontalen gekippt auf den Tragarmen der Tragwelle liegt, wird die Abscheidevorrichtung geöffnet, der Suszeptor angehoben und wie vorgesehen auf die Tragarme der Tragwelle abgelegt.

In den Fällen, in denen es möglich ist, die Fehlanordnung durch Bewegen der Tragwelle zu beseitigen, bleibt die Abscheidevorrichtung geschlossen und es kann auf das Abkühlen der Abscheidevorrichtung auf Umgebungstemperatur verzichtet werden. Befindet sich der Reaktionsraum der Abscheidevorrichtung beim Auftreten einer Fehlanordnung der Tragwelle bereits in einem heißen Zustand, was jedenfalls bei einer Temperatur von 450 °C und höher der Fall ist, wird die Fehlanordnung vorzugsweise beseitigt, ohne die Abscheidevorrichtung unter die genannte Temperatur von 450 °C abzukühlen, besonders bevorzugt, ohne die in der Abscheidevorrichtung erreichte Temperatur abzusenken. Eine Fehlanordnung der Tragwelle lässt sich durch Bewegen der Tragwelle beseitigen, wenn der Grund der Fehlanordnung darin besteht, dass die Tragwelle zwar vertikal, aber nicht entlang der vertikalen Achse durch die Mitte des Vorheizrings ausgerichtet ist, oder darin, dass die Tragwelle von der vertikalen Achse die Mitte des Vorheizrings gekippt ausgerichtet ist.

Das Beobachten der Anordnung des Suszeptors und der Tragwelle bezüglich deren Lage relativ zur Lage des Vorheizrings erfolgt mittels eines Kamerasystems, welches einen Bildausschnitt umfasst, der sich radial vorzugsweise über mindestens einen Bereich erstreckt, der einen Abschnitt des Umfangs der Substratscheibe und einen Abschnitt des inneren Umfangs des Vorheizrings einschließt. Dieser Bildausschnitt beinhaltet auch einen Abschnitt des Spalts zwischen dem Suszeptor und dem Vorheizring. Der vom Kamerasystem aufgezeichnete Bildausschnitt hat eine azimutale Breite von vorzugsweise nicht weniger als 12 °. Die Positionen der Abschnitte werden durch charakteristische Kontrastunterschiede von einer Bildverarbeitungseinrichtung identifiziert, ebenso wie der Abstand des Kamerasystems zur vorzugsweise oberen Stirnfläche des Suszeptors oder die Veränderung dieses Abstands. Gegebenenfalls kann ein Beleuchtungssystem, beispielsweise umfassend eine oder mehrere LED-Lampen, vorgesehen sein, um damit den Reaktionsraum zu beleuchten, solange sich die Abscheidevorrichtung in kaltem Zustand befindet. Während des Drehens der Tragwelle wird der Bildausschnitt in festen Abständen aufgezeichnet und ausgewertet. Die Bildverarbeitungseinrichtung ermittelt aus zeitlichen Veränderungen der genannten Positionen zueinander und aus zeitlichen Schwankungen des genannten Abstands, ob die angesprochenen Fehlanordnungen des Suszeptors und/oder der Tragwelle vorliegen. Eine Steuerungseinrichtung erzeugt auf der Grundlage des Ergebnisses der Ermittlung Steuerungssignale, um eine Antriebseinheit zum Verschieben und Kippen der Tragwelle mit dem Ziel in Bewegung setzen, eine vorliegende Fehlanordnung durch Bewegen der Tragwelle zu beseitigen.

Die Bildverarbeitungseinrichtung kann beispielsweise den in US2016 0 125 589 A1 beschriebenen Algorithmus verwenden oder vorzugsweise eine Bildverarbeitung vornehmen, die den Sobel-Operator zur Kantendetektion einsetzt.

Das Kamerasystem umfasst mindestens eine Kamera oder vorzugsweise mindestens zwei Kameras, die zwei Bildausschnitte mit azimutalem Abstand von 90° zueinander aufzeichnen. Es ist von Vorteil, die Daten der Auswertung mittels der Bildverarbeitungseinrichtung für Vergleichszwecke zu speichern, die erhalten werden, wenn die Abscheidevorrichtung in kaltem Zustand ist und keine der genannten Fehlanordnungen vorliegt. Insbesondere ist es vorteilhaft, den jeweiligen Bildausschnitt hinsichtlich der Breite des Spalts zwischen dem Suszeptor und dem Vorheizring auszuwerten, wenn die Tragwelle und der Suszeptor wie vorgesehen angeordnet sind, und die Breite des Spalts zu speichern.

Die untere Kuppel der Abscheidevorrichtung und die Antriebseinrichtung sind vorzugsweise über einen Faltenbalg verbunden, so dass eine verschiebende und/oder kippende Bewegung der Tragwelle relativ zur unbewegt bleibenden unteren Kuppel im Bedarfsfall ausgelöst werden kann, ohne dass Umgebungsatmosphäre zur Tragwelle gelangt.

Um Vibrationen zu dämpfen, ist bevorzugt, am sogenannten "base ring", der die obere und untere Kuppel auf Abstand hält, außen ein oberes Ende eines Stützarms zu befestigen, und dessen unteres Ende an der Antriebseinrichtung zum Verschieben und Kippen der Tragwelle zu montieren.

Die Antriebseinrichtung zum Verschieben und Kippen der Tragwelle des Suszeptors umfasst mindestens die notwendige Anzahl von Aktuatoren, um das Verschieben der Tragwelle in x-Richtung und in y-Richtung und das Kippen der Tragwelle um eine Drehachse parallel zur x-Richtung und um eine Drehachse parallel zur y-Richtung ausführen zu können. Dementsprechend werden beispielsweise vier Aktuatoren bereitgestellt, wobei jeder von diesen eine der Bewegungen veranlasst. Die Aktuatoren sind vorzugsweise piezoelektrische Stellelemente.

Das Beseitigen der erwähnten Fehlanordnungen durch Bewegen der Tragwelle erfolgt beim Auftreten der Fehlanordnung in heißem Zustand der Abscheidevorrichtung vorzugsweise auch in heißem und geschlossenem Zustand der Abscheidevorrichtung.

Ist die Tragwelle zwar wie vorgesehen vertikal, aber nicht entlang der vertikalen Achse durch die Mitte des Vorheizrings ausgerichtet und liegt der Suszeptor wie vorgesehen auf den Tragarmen, wird beim Drehen des Suszeptors um die Tragwelle beobachtet, dass sich die Breite des Spalts im Bildausschnitt der Kamera des Kamerasystems von der erwarteten gespeicherten Breite unterscheidet oder, falls das Kamerasystem zwei im azimutalen Abstand von 90° angeordnete Kameras umfasst, dass die jeweils beobachtete Breite des Spalts unterschiedlich ist. In diesem Fall besteht eine Fehlanordnung der Tragwelle bezüglich deren Lage relativ zur Lage des Vorheizrings. Sie wird beseitigt durch horizontales Verschieben der Tragwelle in die Position entlang der vertikalen Achse durch die Mitte des Vorheizrings.

Ist die Tragwelle wie vorgesehen entlang der vertikalen Achse durch die Mitte des Vorheizrings ausgerichtet und liegt der Suszeptor relativ zur Lage des Vorheizrings zwar konzentrisch, aber aus der Horizontalen gekippt auf den Tragarmen, wird beim Drehen des Suszeptors um die Tragwelle beobachtet, dass sich der Abstand des Kamerasystems zum Suszeptor im Bildausschnitt der Kamera im Verlauf der Beobachtung sinusförmig ändert. Diese Fehllage des Suszeptors wird durch Umsetzen des Suszeptors in die vorgesehene Lage beseitigt.

Wenn der Suszeptor zwar wie vorgesehen auf den Tragarmen liegt, die Tragwelle aber aus der vorgesehenen Ausrichtung entlang der vertikalen Achse durch die Mitte des Vorheizrings gekippt ist, besteht ebenfalls eine Fehlanordnung der Tragwelle bezüglich deren Lage relativ zur Lage des Vorheizrings. In diesem Fall wird festgestellt, dass die beobachtete Breite des Spalts zwischen dem Suszeptor und dem Vorheizring abweicht von der Breite des Spalts, die beobachtet und gespeichert wurde, als die Tragwelle und der Suszeptor wie vorgesehen angeordnet waren. Diese Fehlanordnung der Tragwelle wird beseitigt durch Kippen der Tragwelle in die vorgesehene Position entlang der vertikalen Achse durch die Mitte des Vorheizrings, so dass die beobachtete Breite des Spalts der gespeicherten Breite des Spalts entspricht.

Es kann beispielsweise vorkommen, dass im kalten Zustand der Abscheidevorrichtung keine Fehlanordnung vorliegt, also die Tragwelle wie vorgesehen entlang der vertikalen Achse durch die Mitte des Vorheizrings ausgerichtet ist und der Suszeptor relativ zur Lage des Vorheizrings horizontal und konzentrisch auf den Tragarmen liegt, und sich erst im Verlauf des Erhitzens der Abscheidevorrichtung eine Fehlanordnung der Tragwelle ausbildet, indem die Tragwelle aus der vorgesehenen Position kippt.

Die Erfindung kann angewendet werden unabhängig davon, ob die Substratscheibe alleine oder zusammen mit dem Suszeptor in die Abscheidevorrichtung geladen wird. Vorzugsweise wird das erfindungsgemäße Verfahren in der geschlossenen Abscheidevorrichtung angewendet und bei einer Betriebstemperatur von mindestens 450 °C.

Der Suszeptor hat in der Draufsicht einen kreisförmigen Außenumfang und weist vorzugsweise eine Vertiefung (pocket) und eine Ablagefläche auf, auf der die Substratscheibe im Randbereich von deren Rückseite aufliegt. Die Substratscheibe liegt vorzugsweise derart auf der Ablagefläche, dass zwischen der Rückseite der Substratscheibe und einem die Vertiefung begrenzenden Boden ein Abstand vorhanden ist. Im Boden der Vertiefung können Löcher eingearbeitet sein, um den Transport von Dotierstoffen von der Rückseite der Substratscheibe in den Reaktionsraum unter dem Suszeptor zu erleichtern. Anstelle der Löcher kann der Boden aus faserhaltigem Material bestehen und wegen der Porosität des Materials den Transport von Dotierstoffen gewährleisten.

Eine Substratscheibe besteht vorzugsweise aus einkristallinem Silizium, ebenso wie die epitaktische Schicht, die auf der Vorderseite der Substratscheibe abgeschieden wird. Der Durchmesser der Substratscheibe beträgt vorzugsweise mindestens 200 mm, besonders bevorzugt mindestens 300 mm.

Die Erfindung umfasst vorzugsweise auch Merkmale, die dem Fachmann bekannt sind, um eine Fehlanordnung der Substratscheibe bezüglich deren Lage relativ zur Lage des Suszeptors festzustellen und zu beseitigen.

Die Erfindung wird nachfolgend mit Verweis auf Zeichnungen an einem Ausführungsbeispiel beschrieben.

### Kurzbeschreibung der Figuren

**Fig. 1** zeigt ein Ausführungsbeispiel einer Abscheidevorrichtung mit erfindungsgemäßen Merkmalen.
**Fig. 2** zeigt das Beobachten des Spalts zwischen dem Suszeptor und dem Vorheizring.

### Liste der verwendeten Bezugszeichen

- **1**: Substratscheibe
- **2**: Suszeptor
- **3**: Vorheizring
- **4**: Ablagefläche
- **5**: Spalt
- **6**: Bildausschnitt
- **7**: Kamerasystem
- **8**: Bildverarbeitungseinrichtung
- **9**: Tragwelle
- **10**: Tragarm
- **11**: Hebewelle
- **12**: Antriebseinrichtung
- **13**: Aktuator (x-Richtung)
- **14**: Aktuator (y-Richtung)
- **15**: Aktuator (Kippwinkel ϕ)
- **16**: Aktuator (Kippwinkel θ)
- **17**: obere Kuppel
- **18**: untere Kuppel
- **19**: Lampenbank
- **20**: Abscheidevorrichtung
- **21**: Steuerungseinrichtung
- **22**: vertikale Achse
- **23**: Rückseite
- **24**: Boden
- **25**: Faltenbalg

### Detaillierte Beschreibung eines erfindungsgemäßen Ausführungsbeispiels.

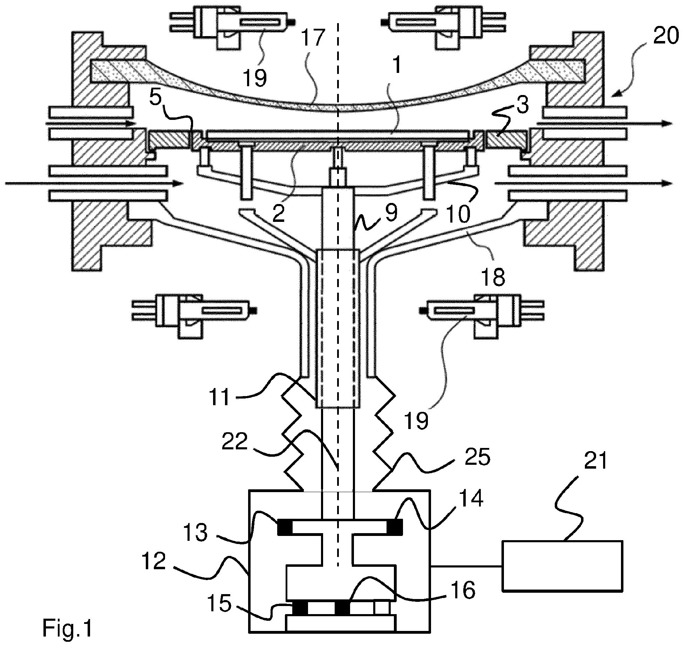

Der Reaktionsraum der in Fig.1 gezeigten Abscheidevorrichtung 20 ist nach oben durch eine obere Kuppel 17 und nach unten durch eine untere Kuppel 18 begrenzt. In die Mitte des Reaktionsraums ragt eine Tragwelle 9, von der an einem oberen Ende Tragarme 10 abzweigen. Die Tragarme 10 stützen einen Suszeptor 2, auf dem während des Abscheidens einer epitaktischen Schicht eine Substratscheibe 1 liegt. Bei der gezeigten Ausführungsform ist vorgesehen, die Substratscheibe 1 im Zuge des Beladens der Abscheidevorrichtung 20 auf einer Hebewelle 11 abzulegen und durch Absenken der Hebewelle 11 auf dem Suszeptor abzulegen. Das Abscheidegas wird über eine zur oberen Kuppel 17 zeigende Vorderseite der Substratscheibe von einem Gaseinlass zu einem Gasauslass geleitet, die an einer Seitenwand der Abscheidevorrichtung angeordnet sind. Zwischen der Seitenwand der Abscheidevorrichtung und dem Suszeptor 2 ist ein Vorheizring 3 angeordnet. Des Weiteren kann auch ein entsprechender Gaseinlass und Gasauslass für Spülgas vorgesehen sein, das unter dem Suszeptor hindurch parallel zu dessen nach unten weisenden Seite durch den Reaktionsraum geleitet wird. Pfeile deuten die Fließrichtung der Gasflüsse an. Von außen wird der Reaktionsraum durch Lampenbänke 19 beheizt, die Strahlungsenergie durch die obere und untere Kuppel 17 und 18 einstahlen.

In der vorgesehenen Anordnung des Suszeptors 2 bezüglich dessen Lage relativ zur Lage des ihn umgebenden Vorheizrings 3 ist zwischen dem Vorheizring 3 und dem Suszeptor 2 ein Spalt 5 vorgesehen, dessen Breite entlang des äußeren Umfangs des Suszeptors und des inneren Umfangs des Vorheizrings konstant ist. Die Achse durch die Mitte des Suszeptors 2 und die vertikale Achse 22 durch die Mitte des Vorheizrings 3 liegen deckungsgleich. In der vorgesehenen Anordnung der Tragwelle 9 bezüglich deren Lage relativ zur Lage des Vorheizrings 3 hat der Spalt 5 entlang des äußeren Umfangs des Suszeptors 2 und des inneren Umfangs des Vorheizrings eine konstante Breite, und beim Drehen der Tragwelle liegen die Drehachse der Drehung und die vertikale Achse 22 deckungsgleich.

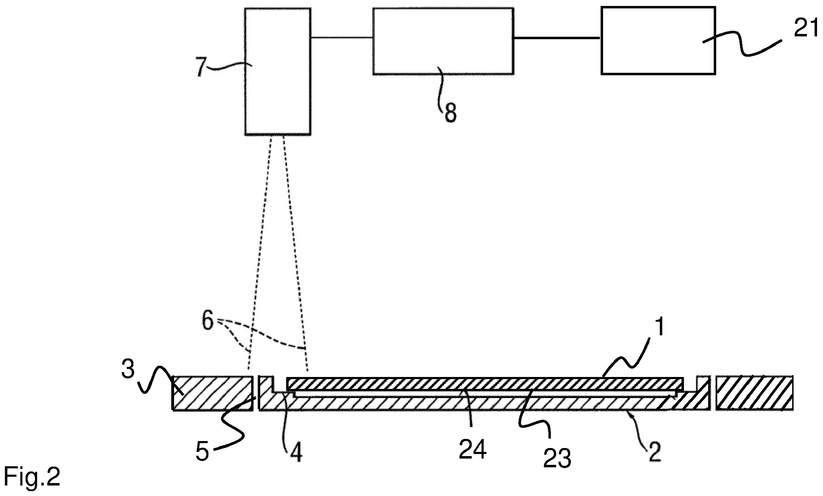

Eine Fehlanordnung des Suszeptors 2 bezüglich dessen Lage relativ zur Lage des ihn umgebenden Vorheizrings 3 liegt vor, wenn der Suszeptor 2 zwar horizontal, aber exzentrisch zum Vorheizring auf den Tragarmen 10 liegt, oder wenn der Suszeptor 2 nicht horizontal auf den Tragarmen 10 liegt, also in einer Ebene liegt, die nicht orthogonal zur vertikalen Achse 22 ausgerichtet ist. Dann ändert sich im ersten Fall die beobachtete Breite des Spalts 5 zwischen dem Suszeptor 2 und dem Vorheizring 3 und im zweiten Fall variiert der Abstand des Suszeptors 2 zu einem Kamerasystem 7 (Fig.2), mit der die Breite des Spalts 5 beim Drehen des Suszeptors 2 mittels der Tragwelle 9 beobachtet wird.

Eine Fehlanordnung der Tragwelle 9 bezüglich deren Lage relativ zur Lage des sie umgebenden Vorheizrings 3 liegt vor, wenn die beobachtete Breite des Spalts 5 zwischen dem Suszeptor 2 und dem Vorheizrings 3 variiert, weil die Tragwelle 9 zwar vertikal ausgerichtet ist, aber nicht entlang der vertikalen Achse 22 durch die Mitte des Vorheizrings 3. Eine Fehlanordnung der Tragwelle 9 bezüglich deren Lage relativ zur Lage des sie umgebenden Vorheizrings 3 liegt auch vor, wenn sich die beobachtete Breite des Spalts 5 im Vergleich zu einer gespeicherten Breite des Spalts 5 geändert hat, weil die Tragwelle 9 aus der vorgesehenen Lage gekippt ist, also die Drehachse der Tragwelle 9 und die vertikale Achse 22 durch die Mitte des Vorheizrings 3 beim Drehen des Suszeptors 2 nicht parallel angeordnet sind.

Das in Fig.2 gezeigte Kamerasystem 7 umfasst eine Kamera zum Beobachten eines Bildausschnitts 6 während des Drehens des Suszeptors 2 mittels der Tragwelle 9. Der Bildausschnitt 6 erfasst einen sich radial erstreckenden Bereich, der vorzugsweise einen Abschnitt des äußeren Umfangs der Substratscheibe 1, einen Abschnitt des äußeren Umfangs des Suszeptors 2, und einen Abschnitt des inneren Umfangs des Vorheizrings 3 einschließt und damit auch einen Abschnitt des Spalts 5 zwischen dem Suszeptor 2 und dem Vorheizring 3. Die Substratscheibe 1 liegt in einer Vertiefung (pocket) des Suszeptors 2 auf einer Ablagefläche 4, so dass die Rückseite 23 der Substratscheibe 1 Abstand zum Boden 24 des Suszeptors 2 hat. Die im Bildausschnitt 6 enthaltenen Informationen werden mittels der Bildverarbeitungseinrichtung 8 insbesondere bezüglich der Breite des Spalts 5 und des Abstands des Kamerasystems 7 zum Suszeptor 2 ausgewertet. Mittels Steuerungseinrichtung 21 wird geprüft, ob eine Fehlanordnung des Suszeptors 2 und/oder der Tragwelle 9 vorliegt und gegebenenfalls beim Vorliegen einer Fehlanordnung der Tragwelle 9 ein Signal erzeugt, welches die Antriebseinrichtung 12 (Fig.1) in eine Bewegung versetzt, die vorliegende Fehlanordnung der Tragwelle beseitigt. Beim Vorliegen einer Fehlanordnung des Suszeptors, wird die Abscheidevorrichtung nötigenfalls auf Umgebungstemperatur gebracht und geöffnet, und die Fehlanordnung beseitigt.

Die Antriebseinrichtung 12 hat die besondere Eigenschaft, die Tragwelle 9 verschieben oder kippen zu können und natürlich auch beides gleichzeitig. Eine mögliche Ausführungsform der Antriebseinrichtung 12 ist in Fig.1 dargestellt. Die Bewegung der Tragwelle 9 wird durch Aktuatoren wie piezoelektrische Stellelemente ausgelöst. Zum Verschieben der Tragwelle 9 in der Horizontalen sind Aktuatoren 13 (zum Verschieben in x-Richtung) und 14 (zum Verschieben in y-Richtung) vorgesehen, und der Aktuator 16 zum Kippen der Tragwelle 9 aus der Ansichtsebene von Fig.1 heraus um eine Drehachse parallel zur x-Richtung mit einem Kippwinkel ϕ sowie der Aktuator 15 zum Kippen der Tragwelle 9 in der Ansichtsebene von Fig.1 um eine Drehachse parallel zur y-Richtung mit einem Kippwinkel θ.

Die untere Kuppel 18 der Abscheidevorrichtung 20 ist mit der Antriebseinrichtung 12 durch einen Faltenbalg 25 verbunden, um das Bewegen der Tragwelle 9 zu ermöglichen und um den durch ihn geschaffenen Innenraum gegen einströmende Umgebungsatmosphäre abzudichten.

## Patentansprüche

1. Verfahren zum Abscheiden einer epitaktischen Schicht auf einer Substratscheibe aus Halbleitermaterial, umfassend
das Anordnen der Substratscheibe und eines Suszeptors in einer Abscheidevorrichtung so, dass die Substratscheibe auf dem Suszeptor aufliegt und der Suszeptor von Armen einer Tragwelle gehalten wird;
das Überprüfen, ob eine Fehlanordnung des Suszeptors bezüglich dessen Lage relativ zur Lage eines ihn umgebenden Vorheizrings besteht;
das Überprüfen, ob eine Fehlanordnung der Tragwelle bezüglich deren Lage relativ zur Lage des Vorheizrings besteht;
beim Vorliegen von mindestens einer der Fehlanordnungen, das Beseitigen der jeweiligen Fehlanordnung; und
das Abscheiden der epitaktischen Schicht auf der Substratscheibe.

2. Verfahren nach Anspruch 1, **gekennzeichnet durch** das Beseitigen der Fehlanordnung der Tragwelle durch das Bewegen der Tragwelle in eine vorgesehene Lage.

3. Verfahren nach Anspruch 2, **gekennzeichnet durch**
das Bewegen der Tragwelle bei einer Temperatur von nicht weniger als 450 °C.

4. Vorrichtung zum Abscheiden einer epitaktischen Schicht auf einer Substratscheibe aus Halbleitermaterial, umfassend
einen Suszeptor,
einen Vorheizring,
eine Tragwelle mit Suszeptor-Tragarmen,
ein Kamerasystem zum Beobachten der Breite eines Abschnitts eines Spalts zwischen dem Suszeptor und dem Vorheizring sowie eines Abstands des Kamerasystems zum Suszeptor,
eine Bildverarbeitungseinrichtung zum Feststellen des Vorliegens einer Fehlanordnung des Suszeptors bezüglich dessen Lage relativ zur Lage des Vorheizrings und/oder einer Fehlanordnung der Tragwelle bezüglich deren Lage relativ zur Lage des Vorheizrings,
eine Antriebseinrichtung zum Verschieben und Kippen der Suszeptor-Tragwelle, und eine Steuerungseinrichtung zum Erzeugen eines Signals beim Vorliegen einer Fehlanordnung, wobei das Signal die Antriebseinrichtung in eine Bewegung versetzt, die die vorliegende Fehlanordnung beseitigt.
